# EUROPEAN PATENT APPLICATION

(11) **EP 3 605 366 A1**
(43) Date of publication of application: **05.02.2020**
(21) Application number: 17903842.7
(22) Date of filing: 19.05.2017
(51) Int. Cl.: G06F 17/50

(54) **METHOD AND APPARATUS THEREOF USED IN ENGINEERING FOR CHECKING DEDUCTION OF COMPONENTS IN BIM MODELING**

(30) Priority: 31.03.2017 CN 201710205673
(71) Applicant: Dalian Wanda Group Co., Ltd., Xigang District Dalian Liaoning 116011 (CN)
(72) Inventor: DING, Benxi, Beijing 100022 (CN); QI, Jie, Beijing 100022 (CN); LAI, Jianyan, Beijing 100022 (CN); YIN, Qiang, Beijing 100022 (CN); WANG, Fukui, Beijing 100022 (CN); SANG, Guoan, Beijing 100022 (CN); TAN, Xifeng, Beijing 100022 (CN); YANG, Shuhua, Beijing 100022 (CN); SONG, Yan, Beijing 100022 (CN); LIU, Min, Beijing 100022 (CN); LI, Peng, Beijing 100022 (CN)
(74) Representative: Ipside
(86) International application number: PCT/CN2017/085042
(87) International publication number: WO 2018/176609

(57) **Abstract**

Provided is a method used in engineering for checking deduction of components in BIM modeling, comprising the steps: obtaining a BIM model for which deduction checking needs to be performed and caching component data; according to a set deduction rule, configuring the type of deduction relationship and processing the relationships between the components, and matching the processed components into pairs; obtaining a deduction model according to the configured type of deduction relationship, and obtaining model data; according to the model connection relationship in the model data and the intersection relationship of the model, determining whether said model data conforms to a set deduction relationship rule; if it conforms to said deduction relationship rule, then ending the step; if it does not conform to said deduction relationship rule, then generating alarm information. Also disclosed is an apparatus used in engineering for checking deduction of components in BIM modeling, said apparatus greatly improving efficiency in component deduction checking.

## Description

### FIELD

The present disclosure relates to the technical field of building engineering, and in particular to a method and a device for checking component deduction in a BIM model of a construction project.

### BACKGROUND

In the building engineering, a BIM model plays an important role in engineering cost estimation. In the engineering cost estimation, intersection and overlap in the building information modeling (BIM) model may cause repetitive engineering quantity calculation, thus resulting in an error in cost. If the deduction check can be performed, according to deduction standards and related algorithms, to rapidly identify overlaps based on a deduction logical relationship between components (for example, in a case that a structural wall overlaps a building wall, the building wall is deducted from the structural wall) in the building industry, modifications can be made timely, so as to avoid unnecessary loss. Due to a large number of components in a BIM model of a big project, comparison among all of the components certainly results in low efficiency. By using a rapid searching method, adjacent components can be rapidly determined, and a spatial position relationship between the adjacent components can be checked to determine whether an overlap exists between the adjacent components. Further, a report of overlapped components is submitted, so that the overlapped components can be rapidly positioned based on the report by a designer, thereby facilitating rapid modifications. In the conventional manual method, it is required to check a professional model document by professionals. However, it is impossible to check every component by the manual method due to the large number of components, and therefore only special parts are checked, resulting in multiple omissions.

### SUMMARY

The present disclosure aims to provide a method and a device for checking component deduction in a BIM model of a construction project. By using the rapid deduction technologies, non-professionals can accurately, completely, rapidly and efficiently find out all errors and position error components.

The following technical solutions are provided to solve technical problems.

A method for checking component deduction in a BIM model of a construction project is provided. The method at least includes: acquiring a BIM model to be checked and caching components data; configuring a type of deduction relationship according to a preset deduction rule, processing relationships among components, and pairing each two of the processed components; acquiring a deduction model based on the configured type of deduction relationship, and acquiring model data; and determining whether the model data conforms to a preset deduction relationship rule based on a model connection relationship and a model overlap relationship in the model data, ending the method in a case that the model data conforms to the preset deduction relationship rule, and generating alarm information in a case that the model data does not conform to the preset deduction relationship rule.

In an embodiment, the preset deduction rule at least includes a priority algorithm, a deduction relationship between each two types, and a component overlap algorithm. In the priority algorithm, a type with a high priority is processed before a type with a low priority. In the component overlap algorithm, a component is selected as a filtering condition and another component overlapping the component is acquired rapidly by using a filter interface of Revit.

In an embodiment, the alarm information is a list or a document of error component deduction.

In an embodiment, the method further includes: positioning a component and modifying the component based on the alarm information.

A device for checking component deduction in a BIM model of a construction project is further provided in the present disclosure. The device executes the above method and at least includes a model acquiring module, a caching module, a rule module, an automatic deduction processing module, an overlap processing module, and an error alarming module.

The model acquiring module is configured to read a BIM model to be checked.

The caching module is configured to cache the components data in the model read by the model acquiring module and processed components data.

The rule module is configured to store a preset deduction rule.

The automatic deduction processing module is configured to: configure the type of deduction relationship according to the preset deduction rule, process the relationships among components, pair each two of the processed components, and store the paired components in the caching module.

The overlap processing module is configured to determine whether the model data conforms to the preset deduction relationship rule based on information transmitted by the automatic deduction processing module and information transmitted by the caching module, and generate the alarm information in a case that the model data does not conform to the preset deduction relationship rule.

The error alarming module is configured to receive the alarm information generated by the overlap processing module, and generate a list or a document of error component deduction.

According to the present disclosure, the following beneficial effects can be achieved. With the method provided in the present disclosure, it can be automatically checked whether the connection between identical or different components is corrected and whether an overlap exists between components. Further, with the technical solutions provided in the present disclosure, non-professionals can accurately, completely, rapidly and efficiently find out all errors and position an error component, leading to much higher efficiency than the manual method and an accurate determination result.

### BRIEF DESCRIPTION OF THE DRAWINGS

Figure 1 is a flowchart of a method for checking component deduction in a BIM model of a construction project according to the present disclosure;
Figure 2 is a flowchart of overlap deduction in the method according to an embodiment of the present disclosure; and
Figure 3 is a structural diagram of a device for checking component deduction in a BIM model of a construction project according to the present disclosure.

### DETAILED DESCRIPTION OF EMBODIMENTS

The technical solutions of the present disclosure are further described through embodiments with reference to the drawings.

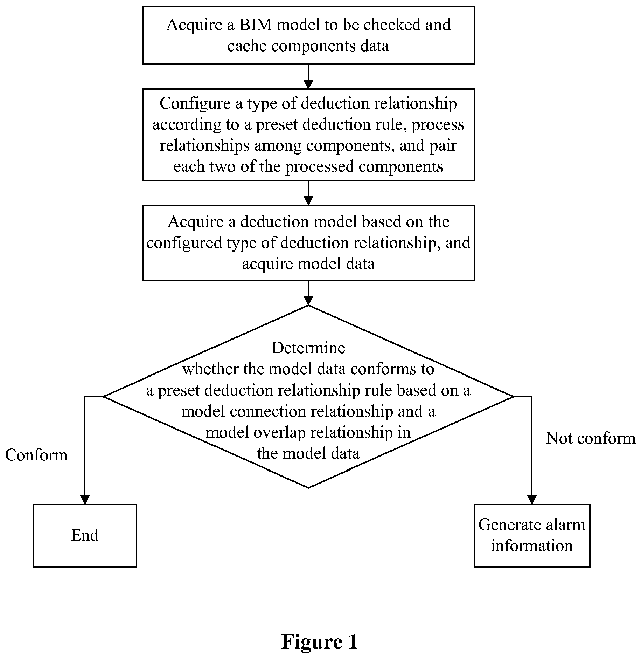

A method for checking component deduction in a BIM model of a construction project is provided in the present disclosure. Referring to Figure 1, the method at least includes: acquiring a BIM model to be checked and caching components data; configuring a type of deduction relationship according to a preset deduction rule, processing relationships among components, and pairing each two of the processed components; acquiring a deduction model based on the configured type of deduction relationship, and acquiring model data; and determining whether the model data conforms to a preset deduction relationship rule based on a model connection relationship and a model overlap relationship in the model data, ending the method in a case that the model data conforms to the preset deduction relationship rule, and generating alarm information in a case that the model data does not conform to the preset deduction relationship rule.

In an embodiment of the present disclosure, the alarm information is a list or a document of error component deduction.

In an embodiment of the present disclosure, the method further includes: positioning a component and modifying the component based on the alarm information.

In an embodiment of the present disclosure, the preset deduction rule at least includes a priority algorithm, a deduction relationship between each two types, and a component overlap algorithm. In the priority algorithm, a type with a high priority is processed before a type with a low priority. In the component overlap algorithm, a component is selected as a filtering condition and another component overlapping the component is rapidly acquired by using a filter interface of Revit.

The deduction check in the method provided in the present disclosure is a pre-process for engineering quantity calculation and cost estimation. The accuracy of the deduction check directly affects the calculated quantity and cost, so that the deduction check is the most important part of an entire checking process in a project. In the present disclosure, components data is cached by using a system caching mechanism, to avoid repetitively reading of the components data in various checks, thereby improving operating efficiency. Each two of the processed components are paired by using a background caching mechanism, to avoid repetitive processing between each two components. In the priority algorithm for various types, a type with a high priority is processed firstly, and processing of a type with a high priority may include processing of a type with a low priority. Processing of a type with a low priority does not include processing of a type with a high priority. Deduction relationships between each two types are set (for example, deducting a building wall from a structural wall, and deducting a floor from a girder). For types that are automatically deducted, a deduction relationship between two components is acquired automatically and is compared with a preset deduction relationship between the same types of components, to determine whether the deduction relationship between the two components conforms to the preset deduction relationship. If the deduction relationship between the two components conforms to the preset deduction relationship, the deduction is correct. If the deduction relationship between the two components does not conform to the preset deduction relationship, the deduction is incorrect. An ID of a component in an incorrect deduction and an error reason are written to a database (cached). In the component overlap algorithm provided in the present disclosure, a component is selected as a filtering condition and another component overlapping the component is rapidly acquired by using a filter interface of Revit. In practices, based on the types of deduction check, an error deduction is filtered out, and an ID of a component in an incorrect deduction and the error reason are written to a database.

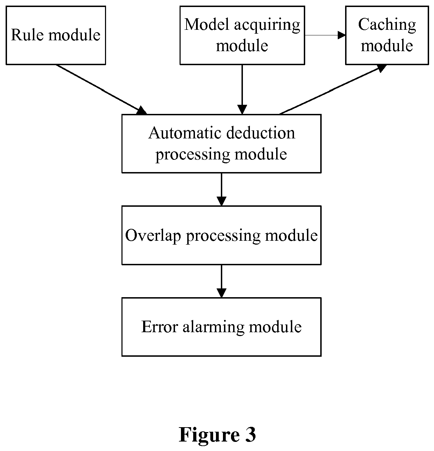

A device for checking component deduction in a BIM model of a construction project is further provided in the present disclosure. The device executes the above described method. Referring to Figure 3, the device at least includes a model acquiring module, a caching module, a rule module, an automatic deduction processing module, an overlap processing module, and an error alarming module. The model acquiring module is configured to read a BIM model to be checked. The caching module is configured to cache components data in the model read by the model acquiring module and processed components data. The rule module is configured to store a preset deduction rule. The automatic deduction processing module is configured to: configure a type of deduction relationship according to the preset deduction rule, process relationships among components, pair each two of the processed components, and store the paired components in the caching module. The overlap processing module is configured to determine whether model data conforms to a preset deduction relationship rule based on information transmitted by the automatic deduction processing module and information transmitted by the caching module, and generate alarm information in a case that the model data does not conform to the preset deduction relationship rule. The error alarming module is configured to receive the alarm information generated by the overlap processing module, and generate a list or a document of error component deduction.

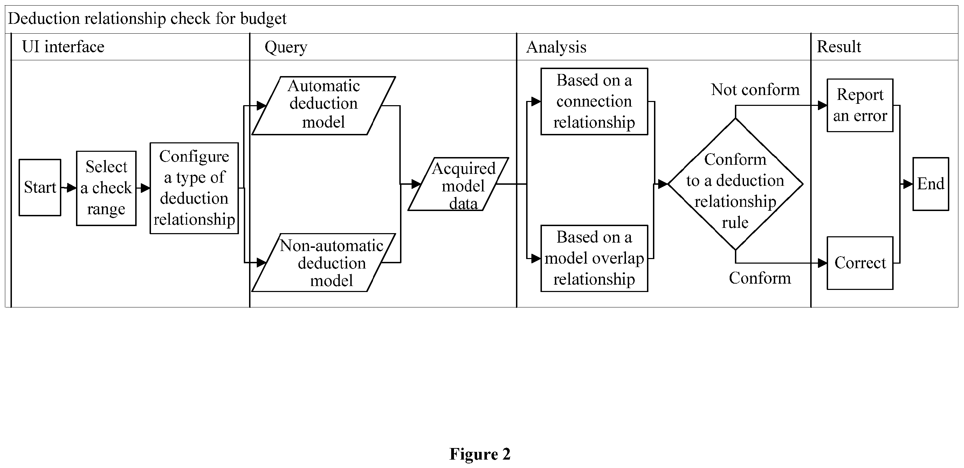

The technical solutions of the present disclosure are further described with reference to Figure 2. In implementing the present disclosure, after a user starts checking, selects deduction check items according to a deduction logical relationship between components in the building industry (for example, in a case that a structural wall overlaps a building wall, the building wall is deducted from the structural wall), and clicks a "check" button, it can be automatically checked whether connection between identical or different components is correct and whether an overlap exists between the components by the method provided in the present disclosure.

The rule module shown in Figure 3 defines the deduction rule, which is a core in the deduction check, and defines deduction relationships between various types of components and priorities of processing various types (for example, with respect to a rule of deducting a building wall from a structural wall, a collision check is performed firstly, to determine whether a collision exists, and if the collision exists, the building wall is deducted from the structural wall, and if the current state is that the structural wall is deducted from the building wall, the deduction relationship between the building wall and the structural wall is adjusted). It is determined whether a collision exists between the components based on a result of the collision check, and then it is determined whether the deduction relationship is correct based on the priorities. If it is determined that the deduction relationship is incorrect, the deduction relationship is adjusted. The deduction rule may be set based on application demands of developers. The principle of setting the deduction rule is conventional technology, which is not described in detail herein.

The automatic deduction processing module in the device may be developed with respect to automatic deduction of components performed based on a deduction rule of the Revit software (which is commonly used in the engineering field, and thus is not described in detail herein). In a process of design, after some components are drawn, the Revit software may automatically perform cutting and connection according to rules of the Revit software, the result of which may not be desired by a designer. The automatic deduction processing module is developed with respect to the components connected in this way. In the automatic deduction processing module, involved components are checked one by one based on a deduction relationship determined by the rule module, to find out a pair of components of an error deduction to prompt the user, so as to improve the efficiency of check, reduce an error probability compared with the manual check, and ensure accuracy of applying the deduction rule. The overlap processing module checks and solves an overlap between components. Some components will not be automatically deducted by the Revit software. If a designer does not design according to the deduction rule, the overlap between components may exist, resulting in increased engineering quantity and cost for the overlap. By the overlap check, overlapping components are listed to prompt the user, so that the user processes the found overlap based on actual demands. A flowchart of the overlap deduction check is shown in Figure 2. In the embodiments of the present disclosure, the error alarming module is capable of interacting with the user, and provides a result of the deduction check to the user in a form of a list or a document, so that the user can position and modify the incorrectly deducted component based on the list or the document.

In summary, with the technical solutions provided in the present disclosure, it can be automatically checked whether the connection between identical or different components is correct, and whether an overlap exists between components. Further, with the technical solutions provided in the present disclosure, non-professionals can accurately, completely, rapidly and efficiently find out all errors and can position the errors rapidly, leading to much higher efficiency than the manual method and an accurate check result.

The sequence of the above embodiments in the present disclosure is arranged only for convenience of description and do not represent preference to the embodiments.

Finally, it should be noted that, the above embodiments are described only for explaining the technical solutions of the present application, and should not be interpreted as limitation to the present disclosure. Although the technical solutions are described in detail with references to the embodiments, those skilled in the art should understand that, the technical solutions in the above embodiments can be modified, or some technical features can be substituted with the equivalents. Such modifications or substitutions do not make the nature of the technical solutions depart from the spirit and scope of the embodiments according to the present disclosure.

## Claims

1. A method for checking component deduction in a BIM model of a construction project, comprising:
acquiring a BIM model to be checked and caching components data;
configuring a type of deduction relationship according to a preset deduction rule, processing relationships among components, and pairing each two of the processed components;
acquiring a deduction model based on the configured type of deduction relationship, and acquiring model data; and
determining whether the model data conforms to a preset deduction relationship rule based on a model connection relationship and a model overlap relationship in the model data, ending the method in a case that the model data conforms to the preset deduction relationship rule, and generating alarm information in a case that the model data does not conform to the preset deduction relationship rule.

2. The method for checking component deduction in a BIM model of a construction project according to claim 1, wherein the preset deduction rule at least comprises:
a priority algorithm, wherein a type with a high priority is processed before a type with a low priority;
a deduction relationship between each two types; and
a component overlap algorithm of selecting a component as a filtering condition and acquiring rapidly another component overlapping the component by using a filter interface of Revit.

3. The method for checking component deduction in a BIM model of a construction project according to claim 1, wherein the alarm information is a list or a document of error component deduction.

4. The method for checking component deduction in a BIM model of a construction project according to claim 1, further comprising:
positioning a component and modifying the component based on the alarm information.

5. A device for checking component deduction in a BIM model of a construction project by using the method according to claim 1, the device at least comprising:
a model acquiring module configured to read the BIM model to be checked;
a caching module configured to cache the components data in the model read by the model acquiring module and processed components data;
a rule module configured to store the preset deduction rule;
an automatic deduction processing module configured to configure the type of deduction relationship according to the preset deduction rule, process the relationships among components, pair each two of the processed components, and store the paired components in the caching module;
an overlap processing module configured to determine whether the model data conforms to the preset deduction relationship rule based on information transmitted by the automatic deduction processing module and information transmitted by the caching module, and generate the alarm information in a case that the model data does not conform to the preset deduction relationship rule; and
an error alarming module configured to receive the alarm information generated by the overlap processing module, and generate a list or a document of error component deduction.
